# EUROPÄISCHE PATENTSCHRIFT

(11) **EP 1 336 329 B1**
(45) Veröffentlichungstag und Bekanntmachung des Hinweises auf die Patenterteilung: **08.07.2009**
(21) Anmeldenummer: 01996987.2
(22) Anmeldetag: 15.11.2001
(51) Int. Cl.: H05K 1/14

(54) **LEITERPLATTENANORDNUNG UND VERFAHREN ZU DERER HERSTELLUNG**
PRINTED CIRCUIT BOARD ASSEMBLY AND METHOD OF PRODUCING IT
SYSTEME DE PLAQUETTES ET PROCEDE DE LEUR FABRICATION

(30) Priorität: 20.11.2000 DE 10057494
(43) Veröffentlichungstag der Anmeldung: 20.08.2003
(73) Patentinhaber: Continental Automotive GmbH, 30165 Hannover (DE)
(72) Erfinder: LOIBL, Josef, 93077 Bad Abbach (DE)
(86) Internationale Anmeldenummer: PCT/DE2001/004314
(87) Internationale Veröffentlichungsnummer: WO 2002/041674

(56) Entgegenhaltungen:
- WO-A-98/44593
- DE-A- 19 961 116
- DE-C- 19 522 173
- US-A- 5 168 430
- US-A- 5 325 268
- US-A- 5 399 904
- US-A- 5 488 256
- US-A- 6 018 463

## Beschreibung

Die Erfindung betrifft eine Leiterplattenanordnung sowie ein Verfahren zur Herstellung einer solchen Anordnung für eine Vorrichtung, wie z.B. ein Automatikgetriebe, eine Motorsteuerung oder ein Bremssystem für Kraftfahrzeuge.

Bei Automatikgetrieben für Kraftfahrzeuge werden zunehmend die Steuerelektronik und zugehörige Sensoren in das Getriebe integriert. Ähnliche Forderungen an eine "Vorort-Elektronik" gibt es beispielsweise bei Motor- und Bremssteuerungen. In sogenannten mechatronischen Steuergeräten werden regelmäßig flexible Leiterplatten, sogenannte Flexfolien, zur Verteilung von elektrischen Signalen und Energie eingesetzt. Insbesondere weisen die Leiterplatten Leiterbahnen auf, die Anschlüsse der jeweiligen Vorrichtung mit Kontaktpads eines Schaltungsträgers verbinden. Auf dem Schaltungsträger ist beispielsweise eine Ansteuerschaltung angeordnet. Obwohl das Layout der Ansteuerschaltung und der Kontaktpads auf dem Schaltungsträger an die Anordnung der Anschlüsse der Vorrichtung angepasst wird, kann eine potentialfreie Kreuzung oder Entflechtung von Leiterbahnen notwendig werden.

Eine gegenüber Öl hermetisch abgedichtete Steuerschaltung ist aus der Patentanmeldung WO 98/44593 bekannt. Eine flexible Leiterplatte ist dicht durch ein Gehäuse der Steuerschaltung hindurchgeführt und in einem Überlappungsbereich mit einem Schaltungsträger der Steuerschaltung über eine Klebung elektrisch kontaktiert.

Die US 5,488,256 offenbart eine Metallgrundplatte als Trägerelement für ein Leistungselement und ein Steuerungselement. Das Leistungselement besteht aus einer Isolationsschicht und einer Metallschicht, die zwischen der Metallgrundplatte und der Isolationsschicht angeordnet ist. Auf der Oberfläche der Isolationsschicht ist ein Leitungsmuster ausgebildet, bei dem elektrische Bauelemente über Bonddrähte mit Kontaktpads elektrisch verbunden sind. Das Steuerungselement weist ebenfalls eine Isolationsschicht auf, auf der ebenfalls ein Leitungsmuster mit elektrischen Bauelementen aufgetragen ist, wobei das Leitungsmuster definierte Leitungsbahnen aufweist, die über Bondverbindungen in elektrischem Kontakt stehen. Die definierten Leitungsbahnen des Steuerungselements können über Bondverbindungen mit den Kontaktpads des Leistungselements in elektrischer Kontaktierung stehen.

Die US 5,325,268 beschreibt einen Verbinder, bei dem sich überkreuzende Verbindungen ohne die Verwendung von Mehrschicht-Metallisierungen oder Durchkontaktierungen bereitgestellt werden. Hierzu wird eine Vielzahl von Leiterbahnen in einer einzigen Metallschicht bereitgestellt, wobei Bondverbindungen von einem oder mehreren elektrischen Bauelementen auf eine gemeinsame Leiterbahn geführt werden.

Zur Entflechtung der elektrischen Verbindungen von Leiterbahnen zu Kontaktpads schlägt die US 5,168,430 vor, ein elektrisches Bauelement in einer Ausnehmung eines isolierenden Substrats anzuordnen und auf dem Substrat Kontaktpads vorzusehen. Die Kontaktpads werden über Bondverbindungen mit dem Bauelement elektrisch verbunden. Das Substrat mit dem Bauelement wird auf einem Leiterrahmen angeordnet, wobei mittels weiteren Bonddrähten eine elektrische Verbindung zwischen den Kontaktpads und Anschlussfingern des Leiterrahmens hergestellt wird.

Die US 5,168,430 offenbart ferner, das Layout von Leiterbahnen an die Abmessungen eines Schaltungsträgers und an die Anordnung der Kontaktpads auf dem Schaltungsträger anzupassen.

Der Erfindung liegt die Aufgabe zugrunde, eine Leiterplattenanordnung für eine Vorrichtung und ein Verfahren zur Herstellung der Leiterplattenanordnung anzugeben, bei welchen eine leichte Entflechtung der elektrischen Verbindungen von Leiterbahnen zu Kontaktpads ermöglicht wird. Ferner soll eine leicht herzustellende Leiterplattenanordnung geschaffen werden, die problemlos an die besondere Ausgestaltung in der Vorrichtung angepasst werden kann.

Die Aufgabe wird gelöst durch eine Leiterplattenanordnung für eine Vorrichtung mit einer ersten Flexeiterplatte, die eine Ausnehmung aufweist, und mit einer zweiten FLexeiterplatte, die in der Ausnehmung angeordnet ist und die einen Schaltungsträgerbereich aufweist, in dem ein Schaltungsträger mit vorgegebenen Abmessungen und mit Kontaktpads mit einer vorgegebenen Anordnung angeordnet ist. Die erste Flexleiterplatte weist Leiterbahnen auf, die bis an die zweite FLexleiterplatte herangeführt sind. Das Layout der Leiterbahnen ist an die besondere Ausgestaltung der Vorrichtung und an die Lage der Anschlüsse dieser Vorrichtung angepasst. Die zweite Flexleiterplatte weist in einem an den Schaltungsträgerbereich angrenzenden Führungsbereich Hilfsleiterbahnen zur Verbindung der Leiterbahnen mit den auf dem Schaltungsträger angeordneten Kontaktpads auf. Die Hilfsleiterbahnen verlaufen im wesentlichen parallel zum Umriss des Schaltungsträgerbereichs. Das Layout der Hilfsleiterbahnen ist an das angepasste Layout der Leiterbahnen, an die Abmessungen des Schaltungsträgers und an die Anordnung der Kontaktpads auf dem Schaltungsträger angepasst. Die Hilfsleiterbahnen verlaufen derart, dass erste Kontaktabschnitte der Hilfsleiterbahnen mit vor dem Führungsbereich liegenden Enden der Leiterbahnen über sich nicht kreuzende Bondverbindungen verbindbar sind.

Eine solche Leiterplattenanordnung kann in einer Anordnung aus einem Schaltungsträger und einer Leiterplatte oder einer Leiterplattenanordnung eingesetzt werden, wobei diese Anordnung ebenfalls die Aufgabe löst. Bei einer solchen Anordnung ist der Schaltungsträger im Schaltungsträgerbereich angeordnet. Zweite Kontaktabschnitte der Hilfsleiterbahnen sind mit den Kontaktpads über Bondverbindungen verbunden. Die Hilfsleiterbahnen verlaufen derart, dass die Bondverbindungen sich nicht kreuzen.

Da die Hilfsleiterbahnen dafür sorgen, dass die Leiterbahnen mit den Kontaktpads elektrisch verbunden werden, muss das Layout der Kontaktpads und Leitungen auf dem Schaltungsträger nicht an das Layout der Leiterbahnen angepasst werden. Folglich kann für verschiedene Layouts der Leiterbahnen derselbe Schaltungsträger mit demselben Layout seiner Kontaktpads und Leitungen verwendet werden. Soll also eine Anordnung aus einem Schaltungsträger und einer Leiterplatte oder einer Leiterplattenanordnung für eine bestimmte Vorrichtung erzeugt werden, so kann folgendes Verfahren angewandt werden, welches ebenfalls die Aufgabe löst:

Die Abmessungen des Schaltungsträgers werden unabhängig von der besonderen Ausgestaltung der Vorrichtung hergestellt. Auch die Kontaktpads und Leitungen auf dem Schaltungsträger werden mit einer von der Vorrichtung unabhängigen und vorgegebenen Anordnung hergestellt. Der Schaltungsträger wird insbesondere ohne Berücksichtigung der Lage von Anschlüssen der Vorrichtung, die mit dem Schaltungsträger elektrisch verbunden werden sollen, erzeugt. Das Layout der Leiterbahnen wird an die besondere Ausgestaltung der Vorrichtung und an die Lage der Anschlüsse dieser Vorrichtung angepasst wird und so konstruiert, dass die Leiterbahnen in ökonomischer Weise die Anschlüsse der Vorrichtung zum Führungsbereich elektrisch hinführen. Das Layout der Leiterbahnen ist also an die besondere Ausgestaltung der Vorrichtung und insbesondere an die Lage der Anschlüsse angepasst. Das Layout der Hilfsleiterbahnen wird an das angepasste Layout der Leiterbahnen, an die Abmessungen des Schaltungsträgers und an die Anordnung der Kontaktpads und Leitungen des Schaltungsträgers zum Zwecke der Verbindung der Leiterbahnen mit den Kontaktpads mit Hilfe von Bondverbindungen angepasst.

Die Entwicklung eines neuen Layouts für Kontaktpads und Leitungen auf einem Schaltungsträger und damit für eine Schaltung auf dem Schaltungsträger ist sehr kostenintensiv und langwierig. Im Vergleich dazu ist die Entwicklung eines Layouts der Leiterbahnen und Hilfsleiterbahnen kostengünstig. Da die Erfindung ermöglicht, unabhängig von der Ausgestaltung der Vorrichtung zur Herstellung der in die Vorrichtung einzusetzenden Anordnung auf denselben bekannten Schaltungsträger zurückzugreifen, ist die Herstellung der Anordnung besonders kostengünstig und einfach.

Dies gilt insbesondere dann, wenn verschiedene Anordnungen in derselben Fertigungslinie erzeugt werden sollen, da Zeiten zum Umrüsten von Bestück- oder Bondautomaten entfallen, und dasselbe Programm zur Bestückung des Schaltungsträgers mit Bauelementen eingesetzt werden kann.

Auch Lager- und Logistikkosten werden eingespart, da zur Herstellung von Anordnungen für verschiedenartige Vorrichtungen gleichartige Schaltungsträger mit derselben Anordnung von Kontaktpads und Leitungen verwendet werden.

Die Herstellung einer Anordnung für eine Vorrichtung, die im Vergleich zu anderen Vorrichtungen einen Teil der für den Schaltungsträger vorgesehenen Bauelemente nicht benötigt, ist ebenfalls kostengünstig und einfach, da derselbe Schaltungsträger verwendet werden kann, der jedoch nur teilweise bestückt wird.

Da ein bekannter und folglich bereits gut getesteter Schaltungsträger für eine Anordnung einer neuen Vorrichtung eingesetzt wird, ist die Qualität der neu entwickelten Anordnung sehr hoch.

Die Abmessungen des Schaltungsträgers und das Layout der Kontaktpads und Leitungen können so entwickelt werden, daß sie an eine bestimmte erste Vorrichtung optimal angepasst sind. Für die erste Vorrichtung sind keine oder nur wenige Hilfsleiterbahnen erforderlich. Für weitere Vorrichtungen jedoch wird der entwickelte Schaltungsträger eingesetzt.

Um die Entflechtung der Leiterbahnen zu vereinfachen, ist es vorteilhaft, wenn der Führungsbereich den Schaltungsträgerbereich umgibt. Es liegen jedoch beliebige Ausgestaltungen des Führungsbereichs im Rahmen der Erfindung. Beispielsweise kann der Führungsbereich L-förmig sein und an zwei Seiten des Schaltungsträgerbereichs angrenzen. Alternativ bildet der Führungsbereich zwei Streifen, die an sich gegenüberliegende Seiten des Schaltungsträgerbereichs angrenzen.

Eine Kreuzung von elektrischen Pfaden zwischen den Anschlüssen und der Kontaktpads zur Entflechtung der elektrischen Pfade wird ermöglicht durch die Bondverbindungen, da quer zu und unter den Bondverbindungen besondere Hilfsleiterbahnen verlaufen können.

Oft werden vor dem Führungsbereich liegende Enden von Leiterbahnen durch Bondverbindungen mit ersten Kontaktabschnitten von Hilfsleiterbahnen verbunden sein. Eine erste Leiterbahn soll dann durch eine Bondverbindung mit dem ersten Kontaktabschnitt einer ersten Hilfsleiterbahn verbunden sein, wenn eine weitere Hilfsleiterbahn vorgesehen ist, die einen größeren Abstand zum Schaltungsträgerbereich aufweist als die erste Hilfsleiterbahn und an der ersten Leiterbahn vorbeigeführt werden muss. Die weitere Hilfsleiterbahn und die Bondverbindung kreuzen sich, ohne sich zu berühren. Die Anordnung weist also Doppelbondungen auf: Ein elektrischer Pfad weist jeweils zwischen der Leiterbahn und der Hilfsleiterbahn und zwischen der Hilfsleiterbahn und dem Kontaktpad eine Bondverbindung auf.

Ist eine solche Kreuzung nicht erforderlich, so kann das vor dem Führungsbereich liegende Ende an der Leiterbahn an den ersten Kontaktabschnitt der Hilfsleiterbahn angrenzen. Eine Bondverbindung ist in diesem Fall überflüssig.

Die Bondverbindungen kreuzen sich nicht, so daß keine Kurzschlüsse entstehen. Um ein Durchhängen der Bondverbindungen und damit Kurzschlüsse zu vermeiden, sollten die Bondverbindungen nicht zu lang sein. Vorzugsweise verlaufen die Hilfsleiterbahnen derart, dass die vor dem Führungsbereich liegenden Enden der Leiterbahnen jeweils vom ersten Kontaktabschnitt der zugeordneten Hilfsleiterbahn bei vorgegebenem Abstand zwischen dem Umriss des Schaltungsträgerbereichs und der Hilfsleiterbahn im wesentlichen den kleinstmöglichen Abstand aufweisen. D. h., dass eine Verbindungslinie zwischen einem vor dem Führungsbereich liegenden Ende einer Leiterbahnen und einem ersten Kontaktabschnitt der zugeordneten Hilfsleiterbahn senkrecht zum Verlauf der Hilfsleiterbahn steht.

Zur Verringerung des Platzbedarfs des Führungsbereichs ist es vorteilhaft, wenn die ersten Kontaktabschnitte der Hilfsleiterbahnen Enden der Hilfsleiterbahnen bilden.

Zur Verhinderung von zu langen Bondverbindungen ist es vorteilhaft, wenn die Hilfsleiterbahnen so verlaufen, dass die Kontaktpads jeweils von dem zweiten Kontaktabschnitt der zugeordneten Hilfsleiterbahn bei vorgegebenem Abstand zwischen dem Umriss des Schaltungsträgerbereichs und der Hilfsleiterbahn im wesentlichen den kleinstmöglichen Abstand aufweisen.

Es liegt im Rahmen der Erfindung, auf der ersten Flexleiterplatte mindestens ein äußeres Bauelement anzuordnen, das mit mindestens einer der Leiterbahnen oder Hilfsleiterbahnen verbunden ist. Dadurch kann beispielsweise ein Gehäuse für den Schaltungsträger kleiner ausgestaltet sein. Dies ist insbesondere dann vorteilhaft, wenn das äußere Bauelement sehr groß ist. Ein solches Bauelement kann beispielsweise ein Kondensator, eine Spule oder ein Halbleiterbauelement sein.

Das Vorsehen eines äußeren Bauelements ist auch dann vorteilhaft, wenn das äußere Bauelement besonders schwer ist. In der Regel werden Bauelemente auf den Schaltungsträger aufgeklebt, während die auf einer Leiterplatte gelötet werden können, so daß besonders schwere Bauelemente auf einem Schaltungsträger schlechter als auf einer Leiterplatte haften.

Darüber hinaus kann eine Leiterplattenanordnung mit mindestens einem äußeren Bauelement für eine Vorrichtung verwendet werden, die im Gegensatz zu anderen Vorrichtungen zusätzlich zu den Bauelementen auf dem Schaltungsträger, ein zusätzliches Bauelement erfordert. Auch für eine solche Vorrichtung ist die Anordnung kostengünstig und einfach herstellbar, da das zusätzliche Bauelement als äußeres Bauelement auf die Flexleiterplatte statt auf den Schaltungsträger aufgebracht wird, so daß die Entwicklung eines neuen Layouts der Kontakte und Leitungen des Schaltungsträgers nicht erforderlich ist.

Aus Kostengründen ist bei einer Leiterplattenanordnung die erste Flexleiterplatte als öldichte Flexleiterplatte ausgebildet, während die zweite Flexleiterplatte vorzugsweise als nicht öldichte und damit kostengünstigere Flexleiterplatte ausgestaltet ist. Eine solche Anordnung ist möglich, wenn die erste Flexleiterplatte und die zweite Flexleiterplatte auf einer tragenden Grundplatte angeordnet sind, die derart durch ein öldichtes Gehäuse geführt ist, dass die Bondverbindungen und die zweite Flexleiterplatte im Gehäuse angeordnet sind, während ein Teil der ersten Flexleiterplatte außerhalb vom Gehäuse angeordnet ist.

Das Vorsehen einer zweiten Flexleiterplatte ist vorteilhaft, wenn sich die Entflechtung der elektrischen Pfade aufgrund einer Vielzahl von Anschlüssen besonders schwierig gestaltet. In diesem Fall kann die zweite Flexleiterplatte mindestens zwei übereinander angeordnete Lagen aufweisen, in denen die Hilfsleiterbahnen angeordnet sind. Bei einer mehrlagigen Flexleiterplatte können sich die Hilfsleiterbahnen der verschiedenen Lagen ohne Kurzschlüsse zu bilden kreuzen, so dass eine Entflechtung leichter realisierbar ist. Da sich die Entflechtung auf die zweite Flexleiterplatte beschränkt, kann die erste Leiterplatte weiterhin lediglich eine Lage aufweisen und folglich kostengünstig sein.

Der Schaltungsträgerbereich kann als Ausnehmung der Flexleiterplatte ausgestaltet sein oder ist ein Teil der Flexleiterplatte. In letzterem Fall können besondere Leiterbahnen unter den Schaltungsträgerbereich durchgeführt werden.

Im Folgenden werden Ausführungsbeispiele der Erfindung anhand der Figuren näher erläutert.

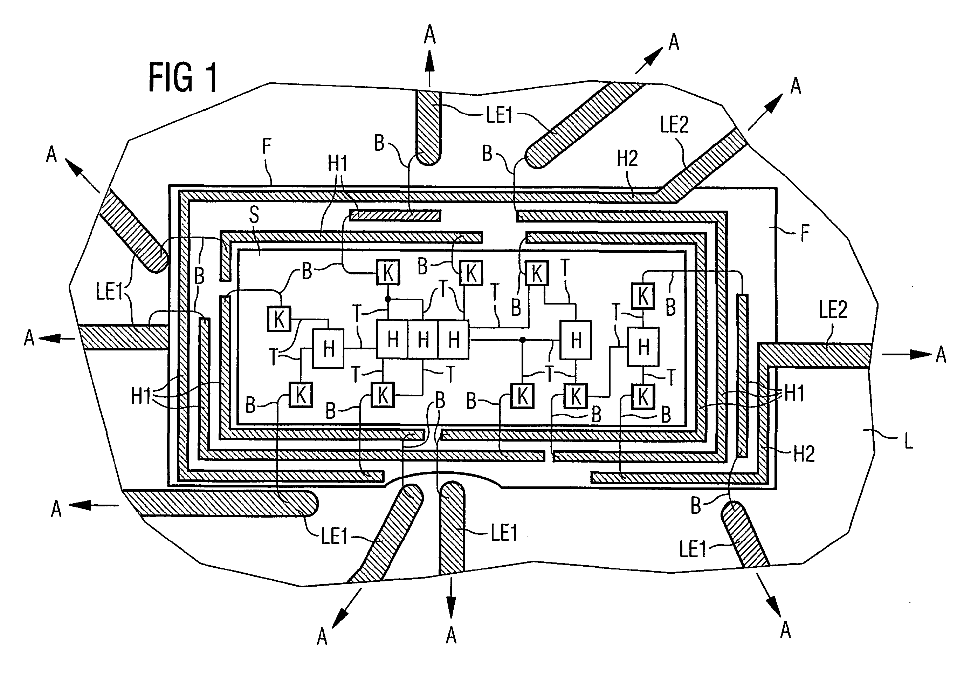

- Figur 1: zeigt eine Aufsicht auf eine erste Anordnung aus einem Schaltungsträger und einer Leiterplatte mit ersten Leiterbahnen, zweiten Leiterbahnen, ersten Hilfsleiterbahnen, zweiten Hilfsleiterbahnen, Bondverbindungen, Kontaktpads, Bauelementen und Leitungen.

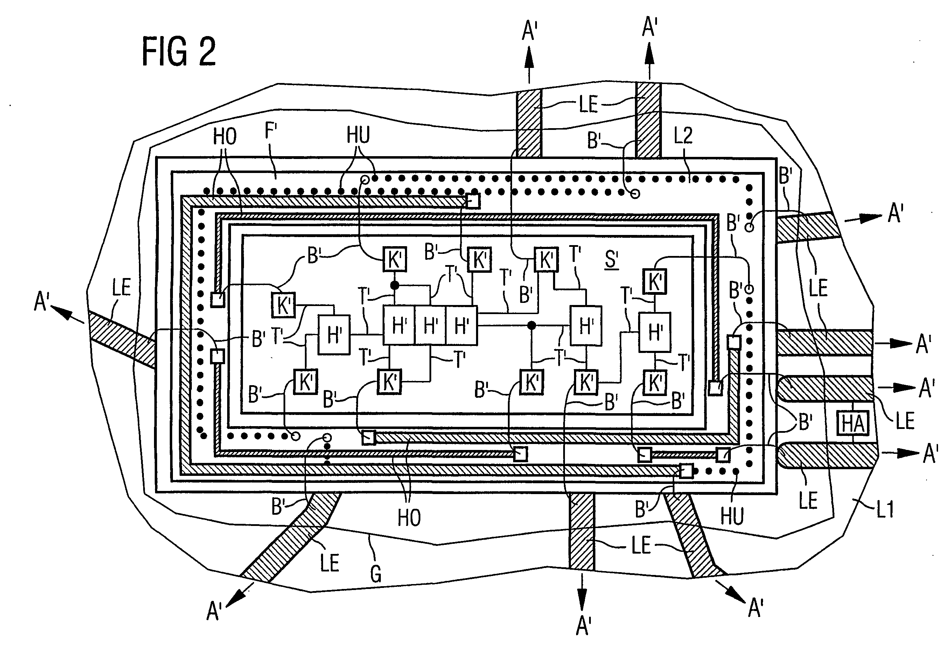

- Figur 2: zeigt eine Aufsicht auf eine zweite Anordnung aus einem Schaltungsträger und einer Leiterplattenanordnung mit einer ersten Leiterplatte, einer zweiten Leiterplatte, Leiterbahnen, oberen Hilfsleiterbahnen, unteren Hilfsleiterbahnen, Bondverbindungen, Kontaktpads, Bauelementen, einem äußeren Bauelement, einem Gehäuse und Leitungen.

In einem ersten Ausführungsbeispiel ist eine erste Anordnung aus einem Schaltungsträger S und einer Leiterplatte L für eine erste Vorrichtung mit Anschlüssen A vorgesehen (siehe Figur 1). Die Leiterplatte L weist einen Schaltungsträgerbereich auf, indem der Schaltungsträger S angeordnet ist. Der Schaltungsträgerbereich kann als Ausnehmung der Leiterplatte L ausgestaltet sein oder ist ein Teil der Leiterplatte L.

Die Leiterplatte L besteht aus einer Basisfolie und einer Deckfolie aus Polyimid. Zwischen der Basisfolie und der Deckfolie befindet sich eine leitende strukturierte Kupferschicht, die erste Leiterbahnen LE1, zweite Leiterbahnen LE2, erste Hilfsleiterbahnen H1 und zweite Hilfsleiterbahnen H2 bildet. Die Leiterplatte L ist also eine einlagige Flexleiterplatte.

Die Leiterbahnen LE1, LE2 sind bis an einen den Schaltungsträgerbereich umgebenden Führungsbereich F der Leiterplatte L herangeführt.

Im Führungsbereich F sind die ersten Hilfsleiterbahnen H1 und die zweiten Hilfsleiterbahn H2 angeordnet. Diese Hilfsleiterbahnen H1, H2 verlaufen im wesentlichen parallel zum Umriss des Schaltungsträgerbereichs. Erste Kontaktabschnitte der ersten Hilfsleiterbahnen H1 liegen den vor dem Führungsbereich F angeordneten Enden der zugeordneten ersten Leiterbahnen LE1 gegenüber und sind mit den ersten Leiterbahnen L1 über Bondverbindungen B verbunden.

Erste Kontaktabschnitte der zweiten Hilfsleiterbahnen H2 grenzen an die vor dem Führungsbereich F liegenden Enden der zweiten Leiterbahn L2 an.

Zweite Kontaktabschnitte der Hilfsleiterbahnen H1, H2 liegen Kontaktpads K des Schaltungsträgers S gegenüber und sind mit den Kontaktpads K über Bondverbindungen B verbunden.

Die Kontaktpads K sind untereinander und mit auf dem Schaltungsträger S geklebten Bauelementen H mit Hilfe von im Schaltungsträger S angeordneten Leitungen T verbunden.

In einem zweiten Ausführungsbeispiel ist eine zweite Anordnung auf einem Schaltungsträger S' und einer Leiterplattenanordnung für eine zweite Vorrichtung mit Anschlüssen A' vorgesehen (siehe Figur 2).

Die Leiterplattenanordnung weist eine erste Leiterplatte L1 und eine zweite Leiterplatte L2 auf. Die erste Leiterplatte L1 weist eine Ausnehmung auf, in der die zweite Leiterplatte L2 angeordnet ist.

Die zweite Leiterplatte L2 weist einen Schaltungsträgerbereich auf, indem der Schaltungsträger S' angeordnet ist.

Die erste Leiterplatte L1 ist als einlagige Flexleiterplatte ausgeführt und weist Leiterbahnen LE auf, die bis an die zweite Leiterplatte L2 herangeführt sind. Die zweite Leiterplatte L2 ist als zweilagige Flexleiterplatte ausgeführt. In einer oberen Lage der zweiten Leiterplatte L2 sind obere Hilfsleiterbahnen HO angeordnet, während in der unteren Lage der zweiten Leiterplatte L2 untere Hilfsleiterbahnen HU angeordnet sind. Die Hilfsleiterbahnen HO, HU sind in einem den Schaltungsträgerbereich umgebenden Führungsbereich F' angeordnet. Die Hilfsleiterbahnen HU, HO verlaufen im wesentlichen parallel zum Umriss des Schaltungsträgerbereichs. Erste Kontaktabschnitte der Hilfsleiterbahnen HU, HO sind mit vor dem Führungsbereich F' liegenden Enden der Leiterbahnen LE über sich nicht kreuzende Bondverbindungen B' verbunden. Zweite Kontaktabschnitte der Hilfsleiterbahnen HU, HO liegen Kontaktpads K' des Schaltungsträgers S' gegenüber und sind mit den Kontaktpads K' über Bondverbindungen B' verbunden.

Die Bondverbindungen B', die zweite Leiterplatte L2 und der Schaltungsträger S' sind in einem öldichten Gehäuse G angeordnet.

Auf dem Schaltungsträger S' sind Bauelemente H' und Leitungen T' vorgesehen, deren Layout dem Layout der Bauelemente H, der Kontaktpads K und der Leitungen T im ersten Ausführungsbeispiel entsprechen.

Die erste Leiterplatte L1 und die zweite Leiterplatte L2 sind auf einer Grundplatte aus z.B. Aluminium festgeklebt (nicht dargestellt).

Auf der ersten Leiterplatte L1 ist ein äußeres Bauelement HA angeordnet. Das äußere Bauelement HA ist als Kondensator ausgestaltet und ist mit zwei der Leiterbahnen LE verbunden.

## Patentansprüche

1. Leiterplattenanordnung für eine Vorrichtung
- mit einer ersten Flexleiterplatte (L1), die eine Ausnehmung aufweist,
- mit einer zweiten Flexleiterplatte (L2), die in der Ausnehmung angeordnet ist und die einen Schaltungsträgerbereich aufweist, in dem ein Schaltungsträger (S') mit vorgegebenen Abmessungen und mit Kontaktpads (K') mit einer vorgegebenen Anordnung angeordnet ist,
- wobei die erste Flexleiterplatte (L1) Leiterbahnen (LE) aufweist, die bis an die zweite Flexleiterplatte (L2) herangeführt sind,
- wobei das Layout der Leiterbahnen (LE) an die besondere Ausgestaltung der Vorrichtung und an die Lage der Anschlüsse dieser Vorrichtung angepasst ist,
- wobei die zweite Flexleiterplatte (L2) in einem an den Schaltungsträgerbereich angrenzenden Führungsbereich (F') Hilfsleiterbahnen (HO, HU) zur Verbindung der Leiterbahnen (LE) mit den auf dem Schaltungsträger (S') angeordneten Kontaktpads (K') aufweist,
- wobei die Hilfsleiterbahnen (HO, HU) im wesentlichen parallel zum Umriß des Schaltungsträgerbereichs verlaufen,
- wobei das Layout der Hilfsleiterbahnen (HO, HU) an das angepasste Layout der Leiterbahnen (LE), an die Abmessungen des Schaltungsträgers (S') und an die Anordnung der Kontaktpads auf dem Schaltungsträger (S') angepasst ist, und
- wobei die Hilfsleiterbahnen (HO, HU) derart verlaufen, daß erste Kontaktabschnitte der Hilfsleiterbahnen (HO, HU) mit vor dem Führungsbereich (F') liegenden Enden der Leiterbahnen (LE) über sich nicht kreuzende Bondverbindungen (B') verbindbar sind.

2. Leiterplattenanordnung nach Anspruch 1,
- bei der die zweite Flexleiterplatte (L2) mindestens zwei übereinander angeordnete Lagen aufweist, in denen die Hilfsleiterbahnen (HO, HU) angeordnet sind.

3. Verfahren zur Herstellung einer Leiterplattenanordnung nach Anspruch 1 oder 2 für eine Vorrichtung,
- bei dem der Schaltungsträger (S') mit unabhängig von der Vorrichtung vorgegebenen Abmessungen und die Kontaktpads (K') und Leitungen (T') auf dem Schaltungsträger (S') mit einer unabhängig von der Vorrichtung vorgegeben Anordnung hergestellt werden,
- bei dem das Layout der Leiterbahnen (LE) an die besondere Ausgestaltung der Vorrichtung und an die Lage der Anschlüsse dieser Vorrichtung angepasst wird und so konstruiert wird, daß die Leiterbahnen (LE) in ökonomischer Weise an die Anschlüsse (A') der Vorrichtung zum Führungsbereich (F') elektrisch hinführen,
- bei dem das Layout der Hilfsleiterbahnen (HO, HU) an das angepasste Layout der Leiterbahnen (LE), an die Abmessungen des Schaltungsträgers (S') und an die Anordnung der Kontaktpads (K') und Leitungen (T') auf dem Schaltungsträger (S') angepaßt wird.

## Claims

1. Printed circuit board assembly for a device comprising
- a first printed circuit board (L1) that has a recess,
- a second printed circuit board (L2) that is located in the recess and that has a circuit carrier zone in which a circuit carrier (S') with predefined dimensions and contact pads (K') with a predefined arrangement is arranged,
- wherein the first printed circuit board (L1) has conductor strips (LE) that are directed toward the second printed circuit board (L2),
- wherein the layout of the conductor strips (LE) is adjusted to the particular configuration of the device and to the position of the terminals of this device,
- wherein the second printed circuit board (L2) has auxiliary conductor strips (HO, HU) in a guide zone (F') that border the circuit carrier zone for connecting the conductor strips (LE) to contact pads (K') that are located on the circuit carrier (S'),
- wherein the auxiliary conductor strips (HO, HU) run substantially parallel to the outline of the circuit carrier zone,
- wherein the layout of the auxiliary conductor strips (HO, HU) is adjusted to the adjusted layout of the conductor paths (LE), to the dimensions of the circuit carrier (S') and to the arrangement of the contact pad on the circuit carrier (S), and
- wherein the auxiliary conductor strips (HO, HU) run in such a way that first contact sections of the auxiliary conductor strips (HO, HU) can be connected to ends of the conductor strips (LE) that lie in front of the guide zone (F') via bonding links (B') that do not intersect.

2. Printed circuit board assembly according to claim 1
- where the second printed circuit board (L2) has at least two layers located one above the other in which the auxiliary conductor strips (HO, HU) are located.

3. Method for producing a printed circuit board assembly according to claim 1 or 2 for a device
- where the circuit carrier (S') is produced with dimensions that are independent of those specified for the device and the contact pads (K') and lines (T') on the circuit carrier (S') are produced with an arrangement that is independent of that specified for the device,
- where the layout of the conductor strips (LE) is adapted to the particular configuration of the device and to the position of the terminals of this device and is designed such that the conductor strips (LE) electrically convey terminals (A') of the device to the guide zone (F') in an economical manner,
- where the layout of the auxiliary conductor strips (H0, HU) is adapted to the adapted layout of the conductor strip (LE), to the dimensions of the circuit carrier (S'), and to the arrangement of the contact pads (K') and lines (T') on the circuit carrier (S').

## Revendications

1. Agencement de plaquettes de circuits imprimés pour un dispositif
- avec une première plaquette de circuits imprimés flexible (L1) qui présente un évidement,
- avec une seconde plaquette de circuits imprimés flexible (L2) qui est disposée dans l'évidement et présente une zone de support de circuits dans laquelle est disposé un support de circuits (S') avec des dimensions prédéfinies et avec des pistes de contact (K') à disposition prédéfinie,
- dans lequel la première plaquette de circuits imprimés flexible (L1) présente des pistes conductrices (LE) qui s'étendent jusqu'à la seconde plaquette de circuits imprimés flexible (L2),
- dans lequel le tracé des pistes conductrices (LE) est adapté à la conception particulière du dispositif et à la position des connexions de ce dispositif,
- dans lequel la seconde plaquette de circuits imprimés flexible (L2) présente, dans une zone de guidage (F') adjacente à la zone de support de circuits, des pistes à semi-conducteurs (HO, HU) pour la liaison des pistes conductrices (LE) aux pistes de contact (K') disposées sur le support de circuits (S'),
- dans lequel les pistes à semi-conducteurs (HO, HU) s'étendent sensiblement parallèlement au contour de la zone de support de circuits,
- dans lequel le tracé des pistes à semi-conducteurs (HO, HU) est adapté au tracé adapté des pistes conductrices (LE), aux dimensions du support de circuits (S') et à la disposition des pistes de contact sur le support de circuits (S'), et
- dans lequel les pistes à semi-conducteurs (HO, HU) s'étendent de manière que des premiers segments de contact des pistes à semi-conducteurs (HO, HU) puissent être reliés à des extrémités, situées en amont de la zone de guidage (F'), des pistes conductrices (LE), par des liaisons (B') ne se croisant pas.

2. Agencement de plaquettes de circuits imprimés selon la revendication 1,
- dans lequel la seconde plaquette à circuits imprimés flexible (L2) comporte au moins deux couches superposées dans lesquelles sont disposées les pistes à semi-conducteurs (HO, HU).

3. Procédé de fabrication d'un agencement de plaquettes de circuits imprimés selon l'une quelconque des revendications 1 ou 2 pour un dispositif,
- dans lequel le support de circuits (S') aux dimensions prédéfinies indépendamment du dispositif et les pistes de contact (K') et lignes (T') sont réalisés sur le support de circuits (S') avec une disposition prédéfinie indépendamment du dispositif,
- dans lequel le tracé des pistes conductrices (LE) est adapté à la conception particulière du dispositif et à la position des connexions de ce dispositif, et est construit de façon que les pistes conductrices (LE) conduisent le courant électrique de manière économique aux connexions (A') du dispositif avec la zone de guidage (F'),
- dans lequel le tracé des pistes à semi-conducteurs (HO, HU) est adapté au tracé adapté des pistes conductrices (LE), aux dimensions du support de circuits (S') et à la disposition des pistes de contact (K') et lignes (T') sur le support de circuits (S').
